# EUROPEAN PATENT APPLICATION

(11) **EP 4 761 531 A1**
(43) Date of publication of application: **17.06.2026**
(21) Application number: 23954431.5
(22) Date of filing: 27.09.2023
(51) Int. Cl.: H10H 29/20

(54) **SEMICONDUCTOR LIGHT-EMITTING DEVICE FOR DISPLAY PIXEL, AND DISPLAY APPARATUS COMPRISING SAME**

(71) Applicant: LG Electronics Inc., Yeongdeungpo-gu Seoul 07336 (KR)
(72) Inventor: CHO, Byoungkwon, Seoul 06772 (KR); LIM, Chunghyun, Seoul 06772 (KR); CHOI, Wonseok, Seoul 06772 (KR); SONG, Hooyoung, Seoul 06772 (KR)
(74) Representative: Vossius & Partner Patentanwälte Rechtsanwälte mbB
(86) International application number: PCT/KR2023/014978
(87) International publication number: WO 2025/070846

(57) **Abstract**

A semiconductor light emitting device for a display pixel according to an embodiment includes a light emitting structure including a first conductivity-type semiconductor layer, an active layer, and a second conductivity-type semiconductor layer; a first electrode disposed below the light emitting structure; and a second electrode disposed on the light emitting structure, and may include a first passivation layer extending from on the second electrode to a side surface of the first conductivity-type semiconductor layer.

## Description

### [Technical Field]

An embodiment relates to a semiconductor light emitting device for a display pixel and a display device including the same.

### [Background Art]

Large-area displays include a liquid crystal display (LCD), an OLED display, and a micro-LED display.

A micro-LED display is a display using, as a display element, a micro-LED which is a semiconductor light emitting device having a diameter or cross-sectional area of 100*µ*m or less.

Since the micro-LED display uses the micro-LED, which is a semiconductor light emitting device, as a display element, the micro-LED display has excellent performance in many characteristics such as contrast ratio, response speed, color reproduction rate, viewing angle, brightness, resolution, lifespan, light emitting efficiency, or luminance.

In particular, the micro-LED display has advantages in that a screen can be separated and coupled in a modular manner so that size or resolution adjustment is free, and in that a flexible display can be implemented.

However, since a large micro-LED display requires millions or more micro-LEDs, there is a technical problem in that it is difficult to transfer the micro-LEDs onto a display panel quickly and accurately.

Transfer technologies that have recently been developed include a pick and place process, a laser lift-off method, or a self-assembly method.

Among these, the self-assembly method is a method in which a semiconductor light emitting device finds an assembly position by itself in a fluid, and is a method advantageous for implementing a large-area display device.

Recently, U.S. Patent No. 9,825,202 has proposed a micro-LED structure suitable for self-assembly, but research on a technology for manufacturing a display through self-assembly of micro-LEDs is still insufficient.

In particular, in the related art, when millions or more semiconductor light emitting devices are rapidly transferred to a large display, transfer speed can be improved, but a transfer error rate can increase, so that there is a technical problem in that a transfer yield is lowered.

Meanwhile, in related technology, a transfer process of a self-assembly method using dielectrophoresis (DEP) has been attempted, but there is a problem in that a self-assembly rate is low due to non-uniformity of DEP force and the like.

Meanwhile, in a display device, when wiring is connected to a chip in a lateral direction, a contact area between a panel electrode and the chip is small, so that electrical performance is poor and a problem of contact failure occurs.

### [Disclosure]

### [Technical Problem]

One of technical problems of an embodiment is to increase an electrical contact area between lateral wiring of a display panel and a semiconductor light emitting device.

In addition, one of technical problems of an embodiment is to prevent mis-assembly during self-assembly.

One of technical problems of an embodiment is to prevent oxidation of a semiconductor light emitting device in a fluid during self-assembly.

One of technical problems of an embodiment is to improve light emitting efficiency of a semiconductor light emitting device.

The technical problems of the embodiment are not limited to those described in this section, and include those that can be grasped through the description of the invention.

### [Technical Solution]

A semiconductor light emitting device according to an embodiment includes a light emitting structure including a first conductivity-type semiconductor layer, an active layer, and a second conductivity-type semiconductor layer; and a first electrode disposed below the light emitting structure;
and a second electrode disposed on the light emitting structure; and may include a first passivation layer extending from on the second electrode to a side surface of the first conductivity-type semiconductor layer.

In addition, in an embodiment, the side surface of the first conductivity-type semiconductor layer may include a first region in contact with the passivation layer and a second region not in contact with the passivation layer.

In addition, in an embodiment, the passivation layer may further include a second passivation layer disposed below the first electrode.

In addition, in an embodiment, the passivation layer may further include a third passivation layer disposed in the second region, and a thickness of the third passivation layer may be thinner than a thickness of the first passivation layer.

In addition, a display device including a semiconductor light emitting device according to another embodiment includes a substrate;
a semiconductor light emitting device disposed on the substrate; and a first panel electrode and a second panel electrode connected to the semiconductor light emitting device, wherein the semiconductor light emitting device includes a first electrode, a first conductivity-type semiconductor layer disposed on the first electrode, an active layer disposed on the first conductivity-type semiconductor layer, a second conductivity-type semiconductor layer disposed on the active layer, and a second electrode disposed on the second conductivity-type semiconductor layer, and further includes a passivation layer extending from on the second electrode to a side surface of the first conductivity-type semiconductor layer, and the first panel electrode may be connected to the first electrode and the first conductivity-type semiconductor layer of the semiconductor light emitting device.

In addition, in an embodiment, the first conductivity-type semiconductor layer may include a first region in contact with the passivation layer and a second region not in contact with the passivation layer, and the second region may be connected to the first panel electrode.

In addition, in an embodiment, the semiconductor light emitting device may further include a second passivation layer disposed below the first electrode.

In addition, in an embodiment, the substrate may further include a plurality of assembly wirings disposed to be spaced apart from each other, and may further include an insulating layer between the plurality of assembly wirings and the semiconductor light emitting device.

In addition, in an embodiment, the display device may further include an adhesive layer disposed between the substrate and the semiconductor light emitting device.

In addition, in an embodiment, the adhesive layer may include a first adhesive layer vertically overlapping the semiconductor light emitting device and a second adhesive layer not vertically overlapping the semiconductor light emitting device, and a thickness of the second adhesive layer may be thinner than a thickness of the first adhesive layer.

### [Advantageous Effects]

A semiconductor light emitting device according to an embodiment and a display device including the same can have a technical effect of increasing an electrical contact area with a panel electrode in a lateral wiring process.

For example, the embodiment can increase the electrical contact area by forming a passivation layer to expose a part of a side surface of the first conductivity-type semiconductor layer so that lateral wiring is connected to the first conductivity-type semiconductor layer.

In addition, the embodiment can have a technical effect of preventing contact failure of lateral wiring.

For example, the embodiment can prevent a problem in which contact failure occurs during a wiring process due to a small contact area of lateral wiring.

In addition, the embodiment can have a technical effect of preventing mis-assembly during self-assembly of the semiconductor light emitting device.

For example, the embodiment can prevent mis-assembly by allowing the semiconductor light emitting device to be easily removed during assembly to a side surface of the semiconductor light emitting device through a shape of the passivation layer.

In addition, the embodiment can have a technical effect of preventing oxidation of an electrode of the semiconductor light emitting device.

For example, the embodiment can prevent oxidation of the electrode in fluid assembly by forming a passivation layer below the electrode of the semiconductor light emitting device.

The technical effects of the embodiment are not limited to those described in this section, and include those that can be grasped through the description of the invention.

### [Description of Drawings]

FIG. 1 is an exemplary view of a living room of a house in which a display device according to an embodiment is disposed.
FIG. 2 is an enlarged view of a first panel area in the display device of FIG. 1.
FIG. 3 is a cross-sectional view taken along line B1-B2 of area A2 of FIG. 2.
FIG. 4 is an exemplary view in which a light emitting device according to an embodiment is assembled on a substrate by a self-assembly method.
FIG. 5 is a conceptual view of a display device including a semiconductor light emitting device that is internally researched.
FIG. 6 is a cross-sectional view of a semiconductor light emitting device according to a first embodiment.
FIG. 7 is a cross-sectional view of a semiconductor light emitting device according to a second embodiment.
FIG. 8 is a cross-sectional view of a semiconductor light emitting device according to a third embodiment.
FIG. 9 is a cross-sectional view of a semiconductor light emitting device according to a fourth embodiment.
FIG. 10 is a cross-sectional view of a display device including a semiconductor light emitting device according to a fifth embodiment.
FIG. 11 is a cross-sectional view of a display device including a semiconductor light emitting device according to a sixth embodiment.
FIG. 12 is a cross-sectional view of a display device including a semiconductor light emitting device according to a seventh embodiment.
FIG. 13A to FIG. 13F are manufacturing process views of a semiconductor light emitting device according to an embodiment.

### [Mode for Invention]

Hereinafter, embodiments disclosed in this specification will be described in detail with reference to the accompanying drawings. In the following description, suffixes "module" and "part" for components used are given or used interchangeably in consideration of ease of writing the specification, and do not have meanings or roles distinguished from each other by themselves. In addition, the accompanying drawings are provided to allow the embodiments disclosed in this specification to be easily understood, and the technical idea disclosed in this specification is not limited by the accompanying drawings. In addition, when an element such as a layer, a region, or a substrate is referred to as being present "on" another element, this includes that the element is present directly on the other element or that another intermediate element may be present therebetween.

The display device described in this specification may include a digital TV, a mobile phone, a smart phone, a laptop computer, a digital broadcasting terminal, a PDA (personal digital assistants), a PMP (portable multimedia player), a navigation, a slate PC, a tablet PC, an ultra-book, a desktop computer, and the like. However, a configuration according to the embodiments described in this specification may also be applied to a device capable of displaying even in a new product type to be developed in the future.

Hereinafter, a light emitting device according to an embodiment and a display device including the same will be described.

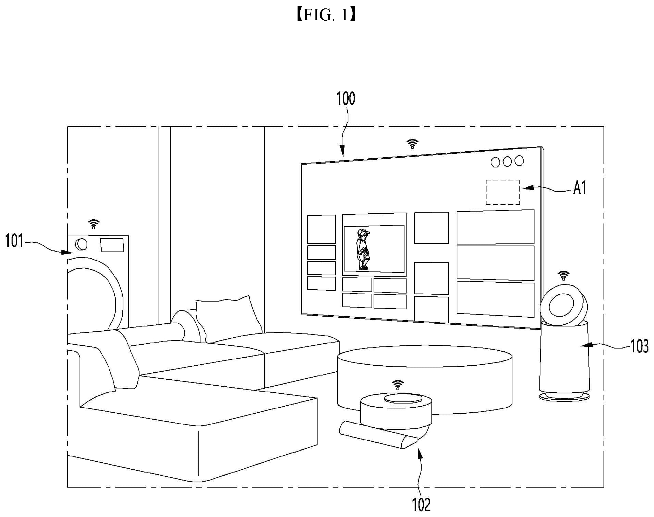

FIG. 1 illustrates a living room of a house in which a display device (100) according to an embodiment is disposed.

The display device (100) of an embodiment can display states of various electronic products such as a washing machine (101), a robot vacuum cleaner (102), and an air purifier (103), can communicate with each electronic product based on IOT, and can also control each electronic product based on user setting data.

The display device (100) according to an embodiment may include a flexible display manufactured on a thin and flexible substrate. The flexible display can be bent or rolled like paper while maintaining characteristics of an existing flat panel display.

In the flexible display, visual information can be implemented by independently controlling light emission of unit pixels arranged in a matrix form. The unit pixel means a minimum unit for implementing one color. The unit pixels of the flexible display can be implemented by a light emitting device. In an embodiment, the light emitting device may be a Micro-LED or a Nano-LED, but is not limited thereto.

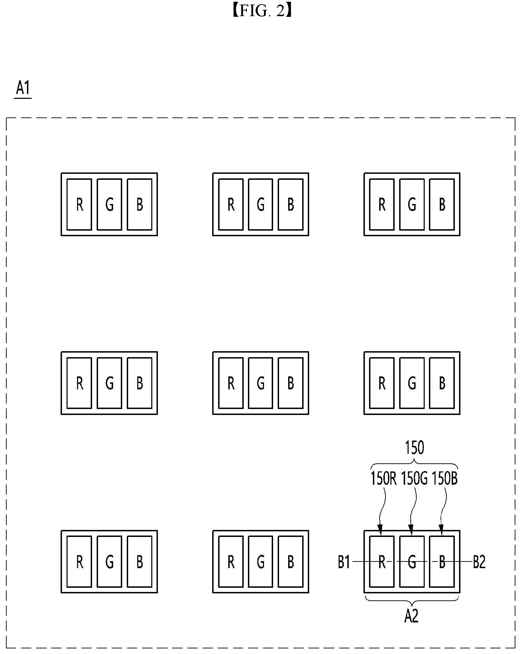

FIG. 2 is an enlarged view of a first panel area (A1) in the display device of FIG. 1.

According to FIG. 2, the display device (100) of an embodiment can be manufactured by mechanically and electrically connecting a plurality of panel areas such as the first panel area (A1) by tiling.

The first panel area (A1) may include a plurality of light emitting devices (150) disposed for each unit pixel (PX in FIG. 2).

For example, the unit pixel (PX) may include a first sub-pixel (PX1), a second sub-pixel (PX2), and a third sub-pixel (PX3). For example, a plurality of red-light emitting devices (150R) may be disposed in the first sub-pixel (PX1), a plurality of green light emitting devices (150G) may be disposed in the second sub-pixel (PX2), and a plurality of blue light emitting devices (150B) may be disposed in the third sub-pixel (PX3). The unit pixel (PX) may further include a fourth sub-pixel in which a light emitting device is not disposed, but is not limited thereto. Meanwhile, the light emitting device (150) may be a semiconductor light emitting device.

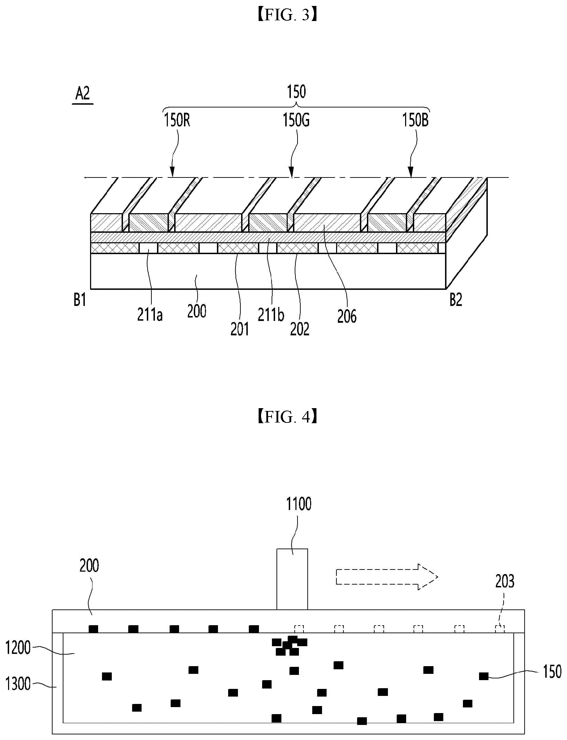

Next, FIG. 3 is a cross-sectional view taken along line B1-B2 of area A2 of FIG. 2.

Referring to FIG. 3, the display device (100) of an embodiment may include a substrate (200), assembly wirings (201, 202), a first insulating layer (211a), a second insulating layer (211b), a third insulating layer (206), and a plurality of light emitting devices (150).

The assembly wirings may include a first assembly wiring (201) and a second assembly wiring (202) spaced apart from each other. The first assembly wiring (201) and the second assembly wiring (202) may be provided to generate a dielectrophoresis force in order to assemble the light emitting device (150). In addition, the first assembly wiring (201) and the second assembly wiring (202) may be electrically connected to an electrode of the light emitting device and may function as an electrode of a display panel.

The assembly wirings (201, 202) may be formed of a light-transmitting electrode (ITO), or may include a metal material having excellent electrical conductivity. For example, the assembly wirings (201, 202) may be formed of at least one of titanium (Ti), chromium (Cr), nickel (Ni), aluminum (Al), platinum (Pt), gold (Au), tungsten (W), and molybdenum (Mo), or an alloy thereof.

A first insulating layer (211a) may be disposed between the first assembly wiring (201) and the second assembly wiring (202), and a second insulating layer (211b) may be disposed on the first assembly wiring (201) and the second assembly wiring (202). The first insulating layer (211a) and the second insulating layer (211b) may be an oxide film, a nitride film, or the like, but are not limited thereto.

The light emitting devices (150) may include a red-light emitting device (150), a green light emitting device (150G), and a blue light emitting device (150B0 in order to form unit pixels (sub-pixels), but are not limited thereto, and may implement red and green, respectively, by including a red phosphor and a green phosphor and the like.

The substrate (200) may be formed of glass or polyimide (Polyimide). In addition, the substrate (200) may include a flexible material such as PEN (Polyethylene Naphthalate) and PET (Polyethylene Terephthalate). In addition, the substrate (200) may be a light-transmitting material, but is not limited thereto.

The third insulating layer (206) may include an insulating and flexible material such as polyimide, PEN, and PET, and may be integrated with the substrate (200) to form one substrate.

The third insulating layer (206) may be a conductive adhesive layer having adhesiveness and conductivity, and the conductive adhesive layer may have ductility so as to enable a flexible function of the display device. For example, the third insulating layer (206) may be an anisotropic conductive film (ACF), or may be a conductive adhesive layer such as an anisotropic conductive medium, or a solution including conductive particles. The conductive adhesive layer may be a layer having electrical conductivity in a vertical direction with respect to a thickness and having electrical insulation in a horizontal direction with respect to the thickness.

The third insulating layer (206) may include an assembly hole (203) into which the light emitting device (150) is inserted. Accordingly, during self-assembly, the light emitting device (150) can be easily inserted into the assembly hole (203) of the third insulating layer (206). The assembly hole (203) may be referred to as an insertion hole, a fixing hole, an alignment hole, or the like.

A spacing between the assembly wirings (201, 202) is formed to be smaller than a width of the light emitting device (150) and a width of the assembly hole (203), so that an assembly position of the light emitting device (150) using an electric field can be fixed more precisely.

The third insulating layer (206) is formed on the assembly wirings (201, 202) to protect the assembly wirings (201, 202) from a fluid (1200) and to prevent leakage of current flowing in the assembly wirings (201, 202). The third insulating layer (206) may be formed as a single layer or multiple layers of an inorganic insulator such as silica and alumina, or an organic insulator.

In addition, the third insulating layer (206) may include an insulating and flexible material such as polyimide, PEN, and PET, and may be integrated with the substrate (200) to form one substrate.

The third insulating layer (206) may be an insulating layer having adhesiveness, or may be a conductive adhesive layer having conductivity. The third insulating layer (206) may have ductility so as to enable a flexible function of the display device.

The third insulating layer (206) may have a partition wall, and the assembly hole (203) may be formed by the partition wall. For example, when the substrate (200) is formed, a part of the third insulating layer (206) is removed, so that each of the light emitting devices (150) can be assembled in the assembly hole (203) of the third insulating layer (206).

The substrate (200) is formed with an assembly hole (203) to which the light emitting devices (150) are coupled, and a surface on which the assembly hole (203) is formed can contact the fluid (1200). The assembly hole (203) can guide an accurate assembly position of the light emitting device (150).

Meanwhile, the assembly hole (203) may have a shape and a size corresponding to a shape of the light emitting device (150) to be assembled at a corresponding position. Accordingly, it is possible to prevent another light emitting device from being assembled in the assembly hole (203) or a plurality of light emitting devices from being assembled.

FIG. 4 is a view illustrating an example in which a light emitting device according to an embodiment is assembled on a substrate by a self-assembly method, and a self-assembly method of the light emitting device will be described with reference to the drawings.

The substrate (200) may be a panel substrate of the display device. In the following description, the substrate (200) is described as a case where the substrate (200) is a panel substrate of the display device, but an embodiment is not limited thereto.

Referring to FIG. 4, a plurality of light emitting devices (150) may be introduced into a chamber (1300) filled with a fluid (1200). The fluid (1200) may be water such as ultrapure water, but is not limited thereto. The chamber may be referred to as a water tank, a container, a vessel, or the like.

Thereafter, the substrate (200) may be disposed on the chamber (1300). According to an embodiment, the substrate (200) may be introduced into the chamber (1300).

As illustrated in FIG. 3, in the substrate (200), a pair of assembly wirings (201, 202) corresponding to each of the light emitting devices (150) to be assembled may be disposed.

Referring to FIG. 4, after the substrate (200) is disposed, an assembly device (1100) including a magnetic material may move along the substrate (200). As the magnetic material, for example, a magnet or an electromagnet may be used. The assembly device (1100) may move in contact with the substrate (200) in order to maximize an area in which a magnetic field affects into the fluid (1200). According to an embodiment, the assembly device (1100) may include a plurality of magnetic materials, or may include a magnetic material having a size corresponding to the substrate (200). In this case, a moving distance of the assembly device (1100) may be limited within a predetermined range.

By a magnetic field generated by the assembly device (1100), the light emitting devices (150) in the chamber (1300) may move toward the assembly device (1100).

During moving toward the assembly device (1100), the light emitting device (150) may enter the assembly hole (203) by a dielectrophoresis force (DEP force) and may contact the substrate (200).

Specifically, the assembly wirings (201, 202) form an electric field by power supplied from the outside, and the dielectrophoresis force can be formed between the assembly wirings (201, 202) by the electric field. By the dielectrophoresis force, the light emitting device (150) can be fixed to the assembly hole (203) on the substrate (200).

By an electric field applied by the assembly wirings (201, 202) formed on the substrate (200), it can be prevented that the light emitting device (150) contacted to the substrate (200) is separated by movement of the assembly device (1100). According to an embodiment, by the self-assembly method using the above-described electromagnetic field, since a time required for each of the light emitting devices (150) to be assembled on the substrate (200) can be drastically shortened, a large-area high-pixel display can be implemented more quickly and economically.

In this case, a predetermined solder layer (not illustrated) may be formed between the light emitting device (150) assembled on the assembly hole (203) of the substrate (200) and an assembly electrode to improve a coupling force of the light emitting device (150).

Next, a molding layer (not illustrated) may be formed in the assembly hole (203) of the substrate (200). The molding layer may be a light-transmitting resin or a resin including a reflective material or a scattering material.

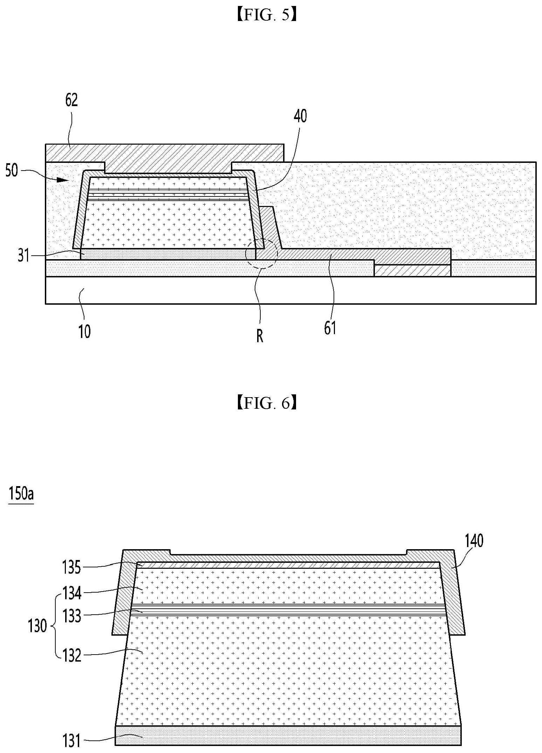

FIG. 5 is a cross-sectional view of a display device including a semiconductor light emitting device researched in an internal technology. Referring to FIG. 5, a semiconductor light emitting device (50) is disposed on a substrate (10), and the semiconductor light emitting device (50) may be electrically connected to a first panel electrode (61) and a second panel electrode (62). Meanwhile, the semiconductor light emitting device (50) may include a passivation layer (40) and a first electrode (31). The passivation layer (40) may be disposed to cover all side surfaces of a light emitting structure. Accordingly, the semiconductor light emitting device may expose only a side surface of the first electrode (31). When a lateral wiring process is performed in a display device, the first panel electrode (61) may contact a side surface region (R) of the first electrode (31). However, since an electrical connection between the first panel electrode (61) and the semiconductor light emitting device (50) is limited only to the side surface region (R), an electrical connection area is small and electrical performance may be degraded. In addition, since the contact area is reduced, a problem of contact failure may occur during a panel electrode process. In addition, even if a part of the passivation layer (40) is etched to be connected, it is difficult to control an etching degree of the passivation layer (40), so that it may rely only on connection with the first electrode (31).

Hereinafter, an embodiment for solving the above problem will be described.

FIG. 6 is a cross-sectional view of a semiconductor light emitting device (150a) according to a first embodiment. The first embodiment may be a vertical semiconductor light emitting device, but is not limited thereto. Referring to FIG. 6, the semiconductor light emitting device (150a) may include a first electrode (131), a light emitting structure (130) disposed on the first electrode (131), and a second electrode (135) disposed on the light emitting structure (130). The light emitting structure (130) may include a first conductivity-type semiconductor layer (132), an active layer (133) disposed on the first conductivity-type semiconductor layer (132), and a second conductivity-type semiconductor layer (134) disposed on the active layer (133).

The first conductivity-type semiconductor layer (132) may be an n-type semiconductor layer, and the second conductivity-type semiconductor layer (134) may be a p-type semiconductor layer, but is not limited thereto. The first conductivity-type semiconductor layer (132), the active layer (133), and the second conductivity-type semiconductor layer (134) may be made of a compound semiconductor material. For example, the compound semiconductor material may be a III-V compound semiconductor material, a II-VI compound material, or the like. For example, the compound semiconductor may be selected from a group consisting of binary compounds selected from a group consisting of GaP, GaAs, GaSb, AlP, AlAs, AlSb, InP, InAs, InSb, and mixtures thereof; ternary compounds selected from a group consisting of GaNP, GaNAs, GaNSb, GaPAs, GaPSb, AlInP, AlNP, AlNAs, AlNSb, AlPAs, AlPSb, InNP, InNAs, InNSb, InPAs, InPSb, GaAlNP, and mixtures thereof; and quaternary compounds selected from a group consisting of AlGaInP, GaAlNAs, GaAINSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof.

For example, the first conductivity-type semiconductor layer (132) may include a first conductivity-type dopant, and the second conductivity-type semiconductor layer (134) may include a second conductivity-type dopant. For example, the first conductivity-type dopant may be an n-type dopant such as silicon (Si), and the second conductivity-type dopant may be a p-type dopant such as boron (B).

The active layer (133) is a region generating light, and may generate light having a specific wavelength band according to material characteristics of a compound semiconductor. In addition, the active layer (133) may have a multiple quantum well structure or a single quantum well structure, and a wavelength band may be determined by an energy bandgap of the compound semiconductor included in the active layer (133). Accordingly, according to the energy bandgap of the compound semiconductor included in the active layer (133), the semiconductor light emitting device of an embodiment may generate UV light, blue light, green light, and red light.

Meanwhile, the semiconductor light emitting device (150a) may include a passivation layer (140). The passivation layer (140) may be disposed to cover a part of the light emitting structure (130). The passivation layer (140) covers the second electrode (135), and may be disposed on a side surface of the light emitting structure (130). The passivation layer (140) may be formed of an oxide film. For example, the passivation layer (140) may include any one of SiOx, SiNx, and Al₂O₃, but is not limited thereto.

In this case, the passivation layer (140) covers all side surfaces of the active layer (133) and the second conductivity-type semiconductor layer (134), and may expose a part of a side surface of the first conductivity-type semiconductor layer (132). A bottom surface of the passivation layer (140) may be positioned below the active layer (133). The first conductivity-type semiconductor layer (132) may include a first region in contact with the passivation layer (140) and a second region not in contact with the passivation layer (140).

Accordingly, since a side surface of the first conductivity-type semiconductor layer is exposed in an embodiment, there is a technical effect in that, in a lateral wiring process in a display panel, a panel electrode contacts not only the first electrode but also the side surface of the first conductivity-type semiconductor layer, thereby securing a large contact area. In addition, light efficiency of the semiconductor light emitting device can be improved.

Meanwhile, during self-assembly of a semiconductor light emitting device, when the semiconductor light emitting device is assembled laterally in an assembly hole, there is a problem in that an assembly rate is reduced because a mis-assembled chip is not removed. Meanwhile, since a passivation layer is formed only partially on a side surface of the semiconductor light emitting device (150a) in an embodiment, even if the semiconductor light emitting device is assembled laterally in an assembly hole, a contact area with a panel is small so that the semiconductor light emitting device is easily removed, thereby having a special technical effect of preventing mis-assembly.

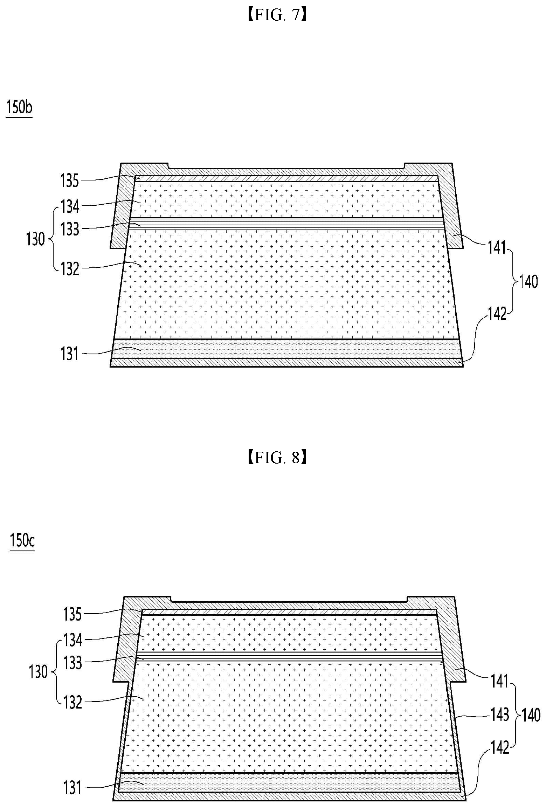

FIG. 7 is a cross-sectional view of a semiconductor light emitting device (150b) according to a second embodiment. The second embodiment may use technical features of the first embodiment. For example, in the second embodiment, the passivation layer (140) may partially expose a side surface of the first conductivity-type semiconductor layer (132) to improve an electrical contact area with lateral wiring, and may have a technical effect of preventing mis-assembly assembled laterally during self-assembly.

Referring to FIG. 7, the passivation layer (140) of the second embodiment may include a first passivation layer (141) extending from on the second electrode (135) to cover one side surface of the first semiconductor layer (132), and a second passivation layer (142) disposed below the first electrode (131). In addition, the first passivation layer (141) and the second passivation layer (142) may include the same material. In addition, the first passivation layer (141) and the second passivation layer (142) may include different materials.

The second passivation layer (142) can prevent oxidation of the first electrode (131), and has a technical effect of being able to protect the first electrode (131).

FIG. 8 is a cross-sectional view of a semiconductor light emitting device (150c) according to a third embodiment. The third embodiment may use technical features of the second embodiment. For example, in the third embodiment, the passivation layer (140) may partially expose a side surface of the first conductivity-type semiconductor layer (132) to improve an electrical contact area with lateral wiring, and may have a technical effect of preventing mis-assembly assembled laterally during self-assembly.

Referring to FIG. 8, the passivation layer (140) of the semiconductor light emitting device (150c) according to the third embodiment may include a first passivation layer (141) extending from on the first electrode (135) to one side surface of the first conductivity-type semiconductor layer (132), a second passivation layer (142) disposed below the first electrode (131), and a third passivation layer (143) disposed between the first passivation layer (141) and the second passivation layer (142).

The third passivation layer (143) may include the same material as the first passivation layer (141), but is not limited thereto.

The third passivation layer (143) may be disposed on a side surface of the first conductivity-type semiconductor layer (132). The side surface of the first conductivity-type semiconductor layer (132) may contact the first passivation layer (141) and the third passivation layer (143). In addition, a thickness of the third passivation layer (143) may be formed to be thinner than a thickness of the first passivation layer (141). Accordingly, the passivation layer can prevent oxidation in a fluid during self-assembly of the semiconductor light emitting device, and can prevent agglomeration between chips. In addition, a step is formed due to a thickness difference, so that, when a chip is assembled laterally, the chip is easily removed, thereby having a technical effect of preventing mis-assembly.

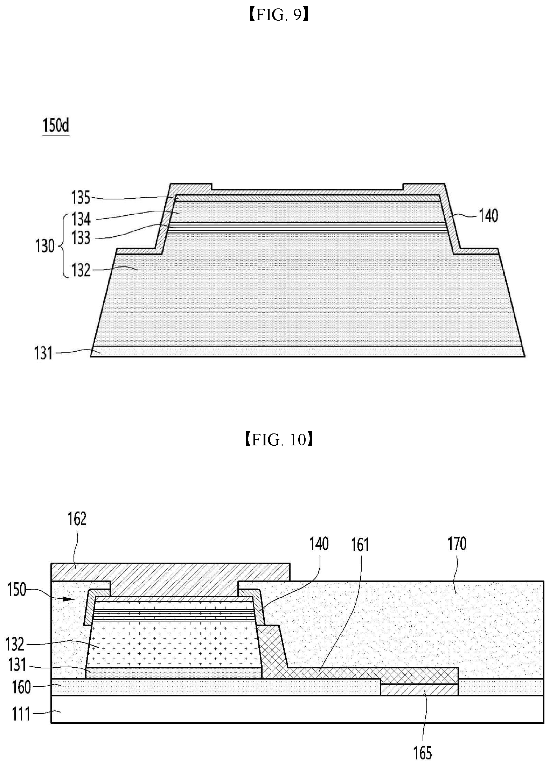

FIG. 9 is a cross-sectional view of a semiconductor light emitting device (150d) according to a fourth embodiment. The fourth embodiment may be a semiconductor light emitting device having a vertical structure. Meanwhile, the semiconductor light emitting device (150d) of the fourth embodiment may include a stepped region in the first conductivity-type semiconductor layer (132). The stepped region may be formed by mesa-etching a part of the first conductivity-type semiconductor layer (132).

In addition, the passivation layer (140) may be disposed from on the second electrode (135) to the stepped region. Accordingly, a part of the first conductivity-type semiconductor layer (132) may be exposed. Accordingly, the fourth embodiment has a technical effect in that a vertical semiconductor light emitting device includes a stepped region in the first conductivity-type semiconductor layer, and can be used as a guide region when forming a passivation layer through the stepped region. In addition, a side surface of the first conductivity-type semiconductor layer is exposed, so that a contact area with a panel electrode can be increased.

FIG. 10 is a cross-sectional view of a display device including a semiconductor light emitting device according to a fifth embodiment. In the fifth embodiment, the semiconductor light emitting device may be the semiconductor light emitting device of the first to fourth embodiments. Referring to FIG. 10, the semiconductor light emitting device may be assembled on an assembly substrate (111). The assembly substrate (111) may include an assembly electrode, and may include a thin film transistor (TFT). The assembly substrate (111) is used as an assembly substrate, and may be used as a display panel substrate through a panel process thereafter.

The semiconductor light emitting device (150) may be a vertical semiconductor light emitting device. A bottom surface of the passivation layer (140) is formed lower than the active layer, and a part of the first conductivity-type semiconductor layer (132) may be exposed by the passivation layer (140).

Meanwhile, an insulating layer (160) may be disposed between the assembly substrate (111) and the semiconductor light emitting device (150), and the insulating layer (160) may expose a TFT electrode (165). The insulating layer (160) may function as a buffer layer protecting a TFT of the assembly substrate.

Meanwhile, a first panel electrode (161) may be disposed on the insulating layer (160) to be connected to the TFT electrode (165) and the semiconductor light emitting device (150).

The first panel electrode (161) may be electrically connected to the first electrode (131) of the semiconductor light emitting device (150) and a side surface of the first conductivity-type semiconductor layer (132).

In addition, a planarization layer (170) may be disposed to cover the semiconductor light emitting device (150) and the first panel electrode (161). An upper surface of the planarization layer (170) may be positioned higher than an upper surface of the semiconductor light emitting device (150), but is not limited thereto.

Accordingly, since a side surface of the first conductivity-type semiconductor layer (132) is exposed by the passivation layer (140) in the fifth embodiment, the first panel electrode (161) is connected not only to the first electrode (131) but also to the side surface of the first conductivity-type semiconductor layer (132), thereby having a technical effect of being able to increase an electrical contact area. Accordingly, electrical performance is improved, and there is a technical effect of being able to solve a problem of contact failure in a wiring process.

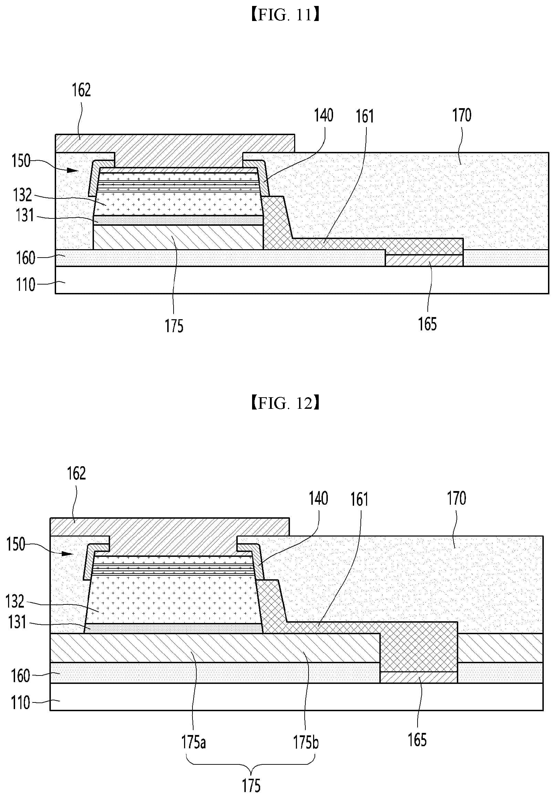

FIG. 11 is a cross-sectional view of a display device including a semiconductor light emitting device according to a sixth embodiment. The sixth embodiment may use technical features of the fifth embodiment. For example, the first panel electrode (161) is connected not only to the first electrode (131) of the semiconductor light emitting device (150) but also to the side surface of the first conductivity-type semiconductor layer (132), thereby having a technical effect of being able to improve an electrical contact area. Referring to FIG. 11, an adhesive layer (175) is disposed on a substrate (110), and the semiconductor light emitting device (150) may be disposed on the adhesive layer (175). The semiconductor light emitting device (150) may be assembled on an assembly substrate (not illustrated) and then transferred and disposed on the substrate (110). The adhesive layer (175) may be formed to be the same as a horizontal width of the semiconductor light emitting device. Accordingly, in the sixth embodiment, since the first panel electrode (161) contacts a side surface of the adhesive layer (175) and is connected to the semiconductor light emitting device (150), there is a technical effect in that contact reliability of the first panel electrode (161) can be improved.

FIG. 12 is a cross-sectional view of a display device including a semiconductor light emitting device according to a seventh embodiment. Referring to FIG. 12, an insulating layer (160) is disposed on the substrate (110), and an adhesive layer (175) may be disposed to cover the insulating layer (160). A horizontal width of the adhesive layer (175) may be larger than a horizontal width of the semiconductor light emitting device (150). In addition, the first panel electrode (161) may be connected to the semiconductor light emitting device (150) from the TFT electrode (165) along the adhesive layer (175). An upper surface of the adhesive layer (175) may include a region contacting the semiconductor light emitting device and a region contacting the first panel electrode.

In addition, the adhesive layer (175) may include a first adhesive layer (175a) vertically overlapping the semiconductor light emitting device (150) and a second region (175b) not vertically overlapping the semiconductor light emitting device (150). Thicknesses of the first adhesive layer (175a) and the second adhesive layer (175b) may be formed to be different. A thickness of the second adhesive layer (175b) may be formed to be thinner than a thickness of the first adhesive layer (175a).

Accordingly, the seventh embodiment has a technical effect in that structural reliability of the first panel electrode can be improved, and contact failure between the first panel electrode and the semiconductor light emitting device can be prevented.

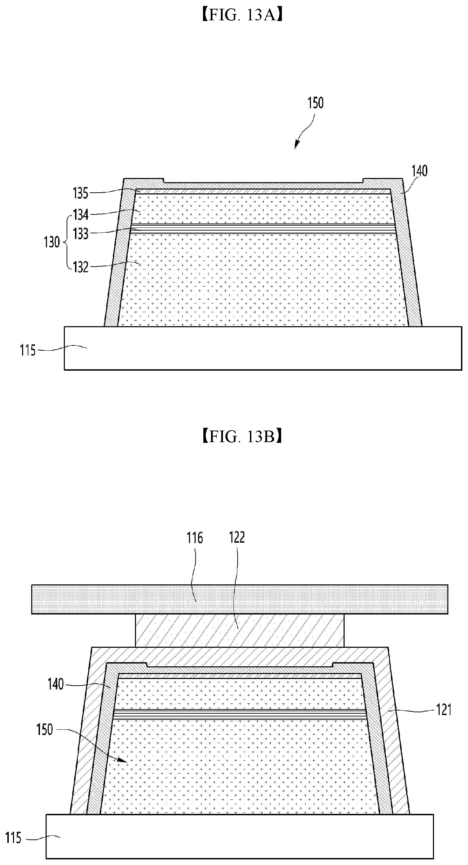

FIGS. 13A to 13F are process views for manufacturing the semiconductor light emitting device of an embodiment. Referring to FIG. 13A, a light emitting structure (130) may be formed on a growth substrate (115). The light emitting structure (130) may include a first conductivity-type semiconductor layer (132), an active layer, and a second conductivity-type semiconductor layer (134). A second electrode (135) may be formed on the light emitting structure (130), and the second electrode (135) may be formed as a transparent electrode. For example, the second electrode (135) may include ITO, IZO, ZnO, and the like, but is not limited thereto. In addition, a passivation layer (140) may be formed to cover both the second electrode (135) and the light emitting structure (130).

Referring to FIG. 13B, a sacrificial layer (121) may be formed to cover an upper portion and a side surface of the passivation layer (140). The sacrificial layer (121) may include Al, but is not limited thereto. In addition, the semiconductor light emitting device (150) on the growth substrate (115) may be adhered to a temporary substrate (116) through a bonding PR (122) formed on an upper portion of the sacrificial layer (121).

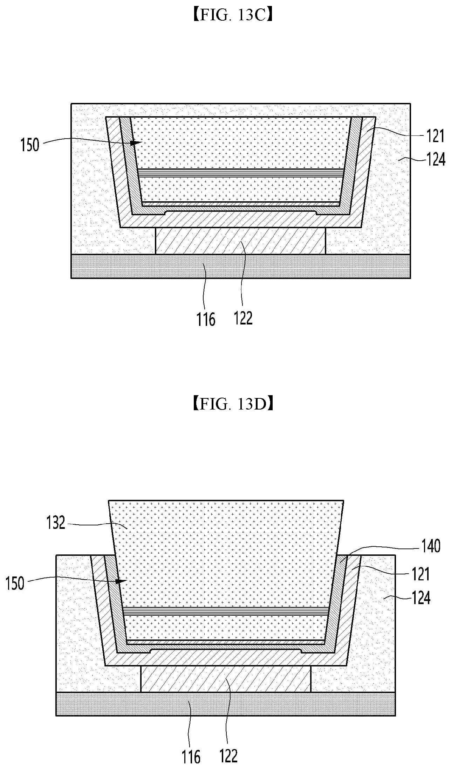

Referring to FIG. 13C, in FIG. 13B, the growth substrate and the temporary substrate may be inverted so that the temporary substrate (116) faces downward. Thereafter, the growth substrate that was in contact with a rear surface of the semiconductor light emitting device (150) may be removed. When removing the growth substrate, a method such as LLO (Laser lift-off) may be used. Thereafter, on the temporary substrate (116), PR (124) may be coated to surround the semiconductor light emitting device (150).

Referring to FIG. 13D, PR (124) may be etched at a height at which an active layer of the semiconductor light emitting device (150) is not exposed. In addition, the sacrificial layer (121) may be etched to correspond to the etched height of the PR (124). In addition, the exposed passivation layer (140) may be etched. Accordingly, in the semiconductor light emitting device (150), a side surface of the active layer is covered by the passivation layer (140), and a part of a side surface of the first conductivity-type semiconductor light emitting device may be exposed.

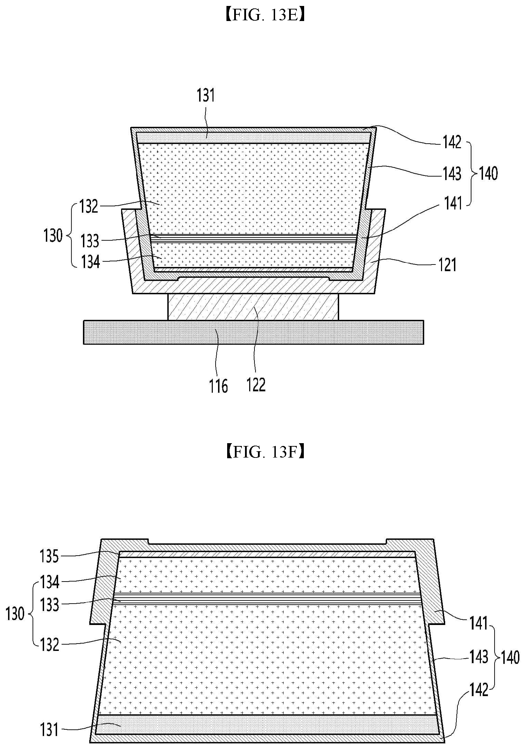

Subsequently, referring to FIG. 13E, a first electrode (131) may be formed on a rear surface of the light emitting structure (130). In addition, a second passivation layer (142) may be formed on the rear surface of the light emitting structure (130). The second passivation layer (142) may be formed of a material different from the first passivation layer (141), but is not limited thereto. A third passivation layer (143) may be formed on a side surface of the first conductivity-type semiconductor layer (132). The third passivation layer (143) may be formed to have a thickness thinner than a thickness of the first passivation layer (141). In addition, the third passivation layer (143) may be formed of a material different from the first passivation layer (141), but is not limited thereto. Accordingly, the passivation layer (140) may be formed to surround the light emitting structure (130). According to a deposition process, the second passivation layer (142) and the third passivation layer (143) may be selectively formed. Thereafter, a process of removing PR and etching the sacrificial layer may be performed.

Referring to FIG. 13F, a temporary substrate may be removed and a semiconductor light emitting device may be formed. The semiconductor light emitting device may include a passivation layer (140) surrounding the light emitting structure (130). The passivation layer may further include a first passivation layer (141) extending from on the second electrode (135) to one side surface of the first conductivity-type semiconductor layer (132), a second passivation layer (142) disposed below the first electrode (131), and a third passivation layer (143) disposed between the first passivation layer (141) and the second passivation layer (142). When assembling the semiconductor light emitting device in a fluid, the passivation layer (140) can prevent oxidation, and can prevent a phenomenon in which chips agglomerate with each other. In addition, a thickness of the third passivation layer (143) may be thinner than a thickness of the first passivation layer (141). Accordingly, a step is formed on a side surface of the semiconductor light emitting device, and when the semiconductor light emitting device is assembled laterally, the semiconductor light emitting device is easily removed, thereby having a technical effect of preventing mis-assembly. In addition, when a part of passivation on a side surface of the semiconductor light emitting device is removed for a lateral wiring process, the thin third passivation layer (143) is removed so that lateral wiring connection is possible, and the thick first passivation layer (141) is not removed and remains, thereby having a technical effect of being able to protect the active layer.

A semiconductor light emitting device according to an embodiment and a display device including the same have a technical effect of being able to increase an electrical contact area with a panel electrode in a lateral wiring process.

For example, an embodiment can increase the electrical contact area by forming a passivation layer to expose a part of a side surface of a first conductivity-type semiconductor layer so that lateral wiring is connected to the first conductivity-type semiconductor layer.

In addition, an embodiment has a technical effect of being able to prevent contact failure of lateral wiring.

For example, an embodiment can prevent a problem in which contact failure occurs during a wiring process due to a small contact area of lateral wiring.

In addition, an embodiment has a technical effect of being able to prevent mis-assembly during self-assembly of a semiconductor light emitting device.

For example, an embodiment can prevent mis-assembly by allowing the semiconductor light emitting device to be easily removed during assembly to a side surface of the semiconductor light emitting device through a shape of a passivation layer.

In addition, an embodiment has a technical effect of being able to prevent oxidation of an electrode of a semiconductor light emitting device.

For example, an embodiment can prevent oxidation of an electrode in fluid assembly by forming a passivation layer below an electrode of the semiconductor light emitting device.

Although embodiments of the present invention have been described above with reference to the embodiments, a person having ordinary skill in the art will readily understand that the present invention can be variously modified and changed without departing from the spirit and scope of the present invention described in the claims below.

### [Industrial Applicability]

An embodiment can be applied to a display field for displaying an image or information.

An embodiment can be applied to a display field for displaying an image or information using a semiconductor light emitting device.

An embodiment can be applied to a display field for displaying an image or information using a micro-scale or nano-scale semiconductor light emitting device.

## Claims

1. A semiconductor light emitting device for a display pixel, comprising:
a light emitting structure including a first conductivity-type semiconductor layer, an active layer, and a second conductivity-type semiconductor layer;
a first electrode disposed below the light emitting structure; and
a second electrode disposed on the light emitting structure,
wherein the semiconductor light emitting device comprises a first passivation layer extending from on the second electrode to a side surface of the first conductivity-type semiconductor layer.

2. The semiconductor light emitting device for a display pixel of claim 1, wherein the side surface of the first conductivity-type semiconductor layer comprises a first region in contact with the passivation layer and a second region not in contact with the passivation layer.

3. The semiconductor light emitting device for a display pixel of claim 1, wherein the passivation layer further comprises a second passivation layer disposed below the first electrode.

4. The semiconductor light emitting device for a display pixel of claim 1, wherein the passivation layer further comprises a third passivation layer disposed in the second region,
and a thickness of the third passivation layer is thinner than a thickness of the first passivation layer.

5. A display device including a semiconductor light emitting device, comprising:
a substrate;
a semiconductor light emitting device for a display pixel disposed on the substrate; and
a first panel electrode and a second panel electrode connected to the semiconductor light emitting device,
wherein the semiconductor light emitting device comprises a first electrode, a first conductivity-type semiconductor layer disposed on the first electrode, an active layer disposed on the first conductivity-type semiconductor layer, a second conductivity-type semiconductor layer disposed on the active layer, and a second electrode disposed on the second conductivity-type semiconductor layer,
wherein the semiconductor light emitting device further comprises a passivation layer extending from on the second electrode to a side surface of the first conductivity-type semiconductor layer, and
wherein the first panel electrode is connected to the first electrode and the first conductivity-type semiconductor layer of the semiconductor light emitting device.

6. The display device including a semiconductor light emitting device of claim 5, wherein the first conductivity-type semiconductor layer comprises a first region in contact with the passivation layer and a second region not in contact with the passivation layer, and
wherein the second region is connected to the first panel electrode.

7. The display device including a semiconductor light emitting device of claim 5, further comprising a second passivation layer disposed below the first electrode.

8. The display device including a semiconductor light emitting device of claim 5, wherein the substrate further comprises a plurality of assembly wirings disposed to be spaced apart from each other,
and further comprises an insulating layer between the plurality of assembly wirings and the semiconductor light emitting device.

9. The display device including a semiconductor light emitting device of claim 5, further comprising an adhesive layer disposed between the substrate and the semiconductor light emitting device.

10. The display device including a semiconductor light emitting device of claim 9, wherein the adhesive layer comprises a first adhesive layer vertically overlapping the semiconductor light emitting device and a second adhesive layer not vertically overlapping the semiconductor light emitting device, and
wherein a thickness of the second adhesive layer is thinner than a thickness of the first adhesive layer.
